# EUROPÄISCHE PATENTSCHRIFT

(11) **EP 2 920 342 B1**
(45) Veröffentlichungstag und Bekanntmachung des Hinweises auf die Patenterteilung: **03.04.2019**
(21) Anmeldenummer: 13798234.4
(22) Anmeldetag: 20.10.2013
(51) Int. Cl.: C30B 13/20, C30B 29/06

(54) **VORRICHTUNG FÜR DAS TIEGELFREIE ZONENZIEHEN VON KRISTALLSTÄBEN**
APPARATUS FOR CONTINUOUS ZONE-MELTING A POLYCRYSTALLINE ROD
APPAREIL DE RECRISTALLISATION PAR FUSION DE ZONE D'UN BARREAU POLYCRISTALLIN

(30) Priorität: 19.11.2012 DE 102012022965
(43) Veröffentlichungstag der Anmeldung: 23.09.2015
(73) Patentinhaber: Forschungsverbund Berlin e.V., 12489 Berlin (DE)
(72) Erfinder: RIEMANN, Helge, 15732 Schulzendorf (DE); WÜNSCHER, Michael, 53501 Grafschaft-Gelsdorf (DE)
(74) Vertreter: Hoffmann, Heinz-Dietrich
(86) Internationale Anmeldenummer: PCT/DE2013/000627
(87) Internationale Veröffentlichungsnummer: WO 2014/075650

(56) Entgegenhaltungen:
- EP-A1- 0 288 880
- EP-A1- 0 292 920
- DD-A1- 264 031
- DE-A1- 2 538 831
- DE-A1- 3 603 766
- JP-A- H08 104 590
- JP-A- 2007 112 640
- US-A1- 2009 068 407

## Beschreibung

### Beschreibung

Die Erfindung betrifft eine Vorrichtung zur Herstellung von Kristallstäben nach dem tiegelfreien Floating Zone(FZ)-Verfahren mit der elektrische Durchschläge an der HF-Induktionsheizspule vermieden werden.

Die Forderung nach möglichst großflächigen Wafern bedingt immer größere Kristalldurchmesser, die in Zukunft über die gegenwärtige technologische Grenze von 200 mm noch hinausgehen werden. Um derartige Kristalle nach dem FZ-Verfahren unter Verwendung von scheibenförmigen Induktionsheizspulen herzustellen, muss generell die angelegte Spannung erhöht werden, damit die erforderliche Leistung in die Schmelzzone induziert werden kann. Mit steigender Spannung steigt dann aber auch die Wahrscheinlichkeit von Überschlägen insbesondere am Spalt und an den Stromzuführungen der Induktionsheizspule.
Das tiegelfreien Zonenziehen von Halbleiterkristallen, insbesondere aus Silizium, nach dem Floating Zone(FZ) Verfahren wird durch Überschläge im Spulenschlitzbereich empfindlich gestört. Erfahrungsgemäß wird hierdurch der Kristall mindestens unbrauchbar, aber zumeist muss der Ziehprozess abgebrochen werden, um Beschädigungen von Anlagenkomponenten vor allem der Induktionsheizspule und deren Zuleitungen zu vermeiden..

Es sind verschiedene Möglichkeiten zur Unterdrückung von Überschlagen an der Induktionsheizspule bekannt, die jedoch nur beschränkt einsetzbar sind.

So wird beispielsweise mit einem Stickstoffzusatz zur Argonatmosphäre im Rezipienten gearbeitet, die deren elektrische Durchschlagfeldstärke erhöht. Diese Methode ist begrenzt, da sich mit steigender Stickstoffkonzentration die Schmelze schneller mit Stickstoff sättigt und sich schädliche Nitridausscheidungen bilden.
Auch bei einer Erhöhung des Drucks der Gasatmosphäre steigt die Durchschlagspannung nach der sog. Paschen-Regel an, jedoch wird bei steigendem Druck der wachsende Kristall immer intensiver gekühlt und kann im Extremfall bersten.

In der Veröffentlichung "Float-Zone silicon crystal growth at reduced RF frequencies" H.-J. Rost et al (Journal of Crystal Growth available online 13. März 2012) wird berichtet, dass bei Verringerung der Frequenz des HF-Stromes der Induktionsheizspule die Wahrscheinlichkeit der Durchschläge reduziert wird. Diese Maßnahme ist wohl effektiv, destabilisiert aber zusätzlich die Schmelzzone.

In der DD 259 423 A1 wird beschrieben, dass ein Isolatorteil zwischen die Leiter vom Ende der Koaxialleitung bis in die Nähe des Kristalls eingeführt wird, wobei die Schmalflächen des in den Rezipienten ragenden Isolatorteils im Temperaturfeld von >600°C der flüssigen Zone liegen. Dabei wird dieser Isolatorteil entweder als eine Verlängerung des koaxialen Isolators oder als eine Zwischenlage gestaltet, die vom Induktor bis zum koaxialen Isolator reicht. Der Isolator selbst besteht aus elektrisch hochbelastbarem Material mit guten Hochfrequenzeigenschaften und geringer Wärmeleitung. Stets durch den Prozess vorhandene Partikel scheiden sich durch elektrostatische Anziehung oder Kondensation an den gekühlten Flächen der Zuleitungen und des Induktors ab. Abgeschiedene Partikel können durch Feldverzerrung und Brückenbildung einen elektrischen Durchbruch bewirken.

In der DE 36 03 766 C2 wird eine Induktionsheizspule für das tiegelfreie Zonenziehen von Kristallstäben vorgestellt, bei der ein temperaturfestes isolierendes Formteil in den Spulenschlitz eingebracht wird, das über den Außenrand der Induktionsheizspule hinausragt. Als Material für dieses wird Quarzglas gewählt.
Die Verwendung von Isolatoren im Schlitzbereich weist aber den Nachteil auf, dass infolge der stets gegenüber dem Gas gesteigerten Dielektrizitätskonstante im Isolator und auch in dessen Umgebung nahe dem Induktor eine elektrische Feldstärkeerhöhung zu verzeichnen ist, die wiederum die Durchschlagsgefahr erhöht. Das als Gegenmaßnahme vorgeschlagene Herausragen des Isolators aus dem Induktorspalt ist jedoch eingeschränkt wegen des möglichen Kontakts mit dem Vorratsstab oder der Schmelze.

Die DE 2422077 A1 offenbart eine Induktionsheizspule, bestehend aus einer einwindigen Flachspule, die zum tiegelfreien Zonenschmelzen von Halbleiterkristallstäben in Schutzgasatmosphäre vorgesehen ist, bei der zur Verringerung von Glimmentladungen und elektrischen Überschlägen der Spulenschlitz unter Vakuum mit einem temperaturfesten Isolierstoff verschlossen ist und dass auch über und unter dem Spulenschlitz dünne Bereiche aus temperaturfestem Isolierstoff flächig angeordnet sind, die mit der Induktionsspule verklebt sind.

In der DE 102005060391 A1 wird einen Apparat zur Herstellung eines Einkristalls nach dem FZ-Verfahren beschrieben, der zumindest eine Kammer aufweist, in der sich ein roher polykristalliner Gussblock und ein gezüchteter Einkristallblock befinden, und eine Induktionsspule, die als Wärmequelle zum Erzeugen einer geschmolzenen Zone zwischen dem rohen polykristallinen Gussblock und dem gezüchteten Einkristallblock dient. Zur Unterdrückung elektrischer Entladungen zwischen der Induktionsheizspule und einem oder mehreren aus dem rohen polykristallinen Gussblock, dem gezüchteten Einkristallblock und der geschmolzenen Zone ist ein isolierendes Bauteil oder eine Schicht eines isolierenden Materials auf der gesamten oder einem Teil der Oberfläche der Induktionsheizspule aufgebracht. Zusätzlich ist zur Unterdrückung elektrischer Entladungen im Spulenschlitz der Induktionsheizspule eine Quarzplatte angeordnet.

Auch bei diesen beiden Lösungen besteht der zuvor bereits beschriebene Nachteil, dass bei der Verwendung von Isolatoren im unmittelbaren Kontakt mit dem Induktor infolge der stets gegenüber dem Gas gesteigerten Dielektrizitätskonstante im Isolator und auch in dessen Umgebung nahe dem Induktor eine elektrische Feldstärkeerhöhung zu verzeichnen ist, die wiederum die Durchschlagsgefahr erhöht. Da die Isolationsschicht bei der D2 als auch bei der D1 keine wirksamen thermischen Isolatoren darstellen, ist durch den direkten Kontakt mit der Induktionsspule auch keine thermische Entkopplung zwischen der Induktionsspule und dem gezüchteten Kristall zu verzeichnen.

Die Aufgabe der Erfindung besteht darin, eine unkomplizierte und leicht handhabbare Vorrichtung zur Herstellung von Kristallstäben nach dem tiegelfreie Floating Zone(FZ)-Verfahren anzugeben, mit welcher sich beim tiegelfreien Zonenziehen hohe Leistungen induzieren lassen, um einen störungsfreien Ablauf des Ziehvorganges bei hohen Kristalldurchmessern zu gewährleisten und dabei insbesondere Durchschläge an der Induktionsspule zu vermeiden.

Die Aufgabe wird erfindungsgemäß gelöst durch eine Vorrichtung mit den Merkmalen des Patentanspruchs 1. Die Vorrichtung zur Herstellung von Kristallstäben nach dem tiegelfreie Floating Zone(FZ)-Verfahren besteht aus einer als Heizquelle dienenden und aus dem Stand der Technik bekannten, nur eine Windung aufweisenden, Induktionsspule mit einer Zentralöffnung, in die der Hauptschlitz, der als Stromzuführung dient, einmündet. Unterhalb der Induktionsspule ist in einem definierten Abstand zur Unterseite der Induktionsspule eine Abschirmung angeordnet, die zumindest den Bereich unterhalb des Hauptschlitzes gegenüber der Schmelze thermisch und strömungstechnisch abschirmt.

Vorzugsweise ist als Abschirmung eine großflächige Platte angebracht, die die gesamte Unterseite der Induktionsspule gegenüber der Schmelze thermisch und strömungstechnisch separiert.
Die Abschirmung besteht aus einem durchschlagfesten Material mit niedrigen dielektrischen Verlusten und geringer Wärmeleitung, z. B. Quarzglas oder einem Keramikmaterial. Die Abschirmung ist derart geformt, dass sie sich den Konturen der Induktionsspule anpasst, so dass die obere Fläche der Abschirmung und die untere Fläche der Induktionsspule nahezu parallel verlaufen. Vorteilhafterweise ist die Abschirmung in einem geringen Abstand zur Induktionsspule angeordnet. Die Abschirmung ist mittels Halterungen mit der Induktionsspule lösbar verbunden, mit denen auch der definierte Abstand zwischen der Induktionsspule und der Schmelze eingestellt werden kann.

Sofern ein prozessbedingter größerer Abstand zwischen Abschirmung und der Schmelzzone erforderlich ist, kann die Abschirmung aber auch unmittelbar unterhalb der Induktionsspule angeordnet sein und diese zum Teil direkt berühren. In diesem Fall sind die Halterungen derart eingestellt, dass kein Zwischenraum zwischen der Abschirmung und der Unterseite der Induktionsspule vorhanden ist. Eine Berührung zwischen Abschirmung und Induktionsspule im Bereich des Hauptschlitzes muss jedoch vermieden werden, da ansonsten dort durch große Unterschiede zwischen den Dielektrizitätskonstanten zwischen Abschirmung und Induktionsspule eine elektrische Feldstärkeerhöhung zu verzeichnen ist, die wiederum die Durchschlagsgefahr erhöht.

Die Abschirmung besteht vorzugsweise aus einer dünnen kreisringförmigen Quarzglas- oder Keramikscheibe, deren Außendurchmesser größer ist als der Durchmesser des Kristalls. Vorzugsweise ist der Durchmesser der Abschirmung auch geringfügig größer als der der Induktionsspule. Die Abschirmung weist eine zentrale Öffnung auf, die in Form und Position der Zentralöffnung der Induktionsspule entspricht.

In einer Ausführungsvariante, bei der nicht die gesamte Induktionsspule gegenüber der Schmelzzone abgeschirmt wird, ist in jedem Fall der Bereich des Hauptschlitzes von der Abschirmung überdeckt. Die Abschirmung besteht beispielsweise aus einem Kreissektor oder einem Streifen, wobei diese Abschirmung den Hauptschlitz um mindestens ca. 1 cm nach beiden Seiten und über den Radius des Kristalls hinaus, überragt.

Weitere vorteilhafte Ausgestaltungen der Erfindung können den Unteransprüchen entnommen werden.

Die beschriebene Abschirmung verhindert einerseits, dass heißes Gas direkt von der Schmelze in den Bereich des Hauptschlitzes aufsteigen und dort Durchschläge verursachen kann. Dieses heiße Gas wird durch die Abschirmung vom Bereich des Hauptschlitzes abgehalten und um die Induktionsspule herum geleitet. Auch werden schwebende Partikel, die sich generell verfahrensbedingt bilden, vom Bereich des Hauptschlitzes und um die Induktionsspule herum gelenkt. Ist die Abschirmung mit einem geringen Abstand unterhalb der Induktionsspule angeordnet, entsteht gleichzeitig zwischen der Abschirmung und der Induktionsspule eine kältere Gasschicht, die insbesondere die Gastemperatur im Hauptsschlitz und dessen Umgebung reduziert.
In einer bevorzugten Ausführung der Erfindung deckt die Abschirmung die Induktionsspule gegenüber der Schmelze vollständig ab. Die Abschirmung ragt über den Durchmesser der Induktionsspule und den Durchmesser des gezogenen Kristalls hinaus.
Die Abschirmung dient in Zusammenwirken mit der Gasschicht zwischen der Abschirmung und der Induktionsspule zusätzlich auch als thermische Isolation zwischen der heißen Schmelze und der wassergekühlten Induktionsspule, indem thermisch bedingte Gasturbulenzen beruhigt und die damit verbunden Wärmeverluste der Schmelze gesenkt werden, wodurch der Wachstumsprozess weniger gestört wird und der wachsende Kristall eine höhere Qualität aufweist. Durch die thermische Entkopplung zwischen Induktionsspule und Schmelze wird außerdem der Prozessenergieverbrauch gesenkt.

Durch die Abschirmung wird eine erhöhte Durchschlagsfestigkeit am Hauptschlitz der Induktionsspule erreicht, so dass eine höhere Spannung an die Induktionsspule angelegt werden kann. Damit kann der Prozess mit höherer Leistung sicher gefahren werden, um z.B. den Durchmesser der Kristalle weiter zu steigern.

Die genannten Vorteile der Erfindung bewirken zusammengenommen, dass höhere Leistungen beherrschbar sind, so dass mit dieser Induktionsspule Kristalle mit großem Durchmesser ohne Überschläge gezogen werden können. Weitere Vorteile der erfindungsgemäßen Induktionsspule bestehen darin, dass es zur Verringerung der Durchschläge nicht oder in geringerem Maße erforderlich ist, den Prozessdruck im Rezipienten weiter zu erhöhen. Es ist ebenso nicht zwingend erforderlich Stickstoff dem Schutzgas zuzusetzen. D.h. es können neben der Spannungserhöhung an der Induktionsspule weitere Parameter für einen optimalen Züchtungsprozess eingestellt werden.

Die Erfindung wird nachstehend an Ausführungsbeispielen näher erläutert. Die Figuren zeigen:
- Fig. 1: Querschnitt durch die erfindungsgemäße Vorrichtung
- Fig. 2: Querschnitt durch die Vorzugsvariante mit Abstand der gesamten Abschirmung
- Fig. 3: Querschnitt durch Vorrichtung mit Abstand nur im Bereich des Hauptschlitzes durch Ausfräsung der Abschirmung
- Fig. 4: Querschnitt durch Vorrichtung mit Abstand nur im Bereich des Hauptschlitzes durch Ausfräsung des Induktors

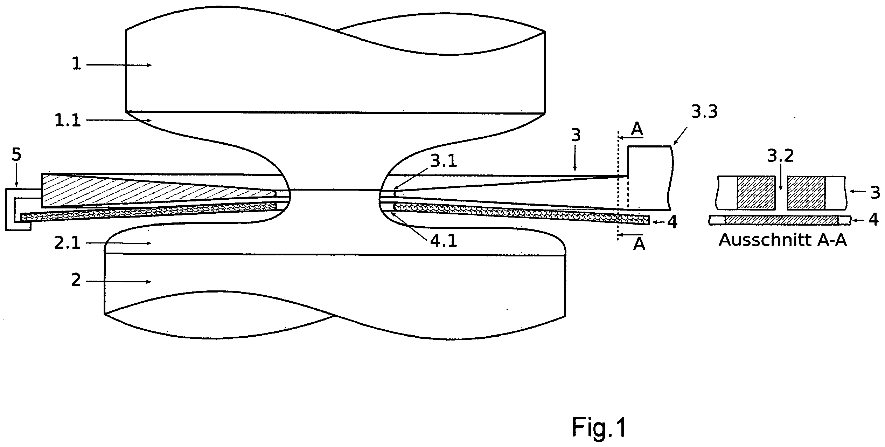

Anhand der Fig. 1 wird eine Vorzugsvariante der erfindungsgemäßen Lösung beschrieben. Im gewählten Beispiel wird ein Kristall **2** nach dem Floating Zone-Verfahren aus einem oberhalb der Induktionsspule angeordneten Vorratsstab **1** nach unten gezogen. In der Fig. 1 wird die erfindungsgemäße Vorrichtung, bestehend aus einer wassergekühlten Induktionsspule **3** und der erfindungsgemäßen Abschirmung **4** sowie der Vorratsstab **1** und der gezogene Kristall **2** dargestellt. Die beschriebene Vorrichtung ist einem nicht dargestellten Rezipienten angeordnet.
In der Fig.1 ist eine Schnittansicht der Vorrichtung zu sehen. Unterhalb des Vorratsstabes **1** ist eine einwindige scheibenförmig ausgebildete runde Induktionsspule **3** angeordnet, die eine runde Zentralöffnung **3.1** und einen Hauptschlitz **3.2** aufweist, an den die beiden Stromzuführungen **3.3** angeschlossen sind. Im gewählten Beispiel ist eine großflächige ringförmige Abschirmung **4** in einem definierten Abstand **a** unterhalb der Induktionsspule **3** angebracht, die die gesamte Induktionsspule **3** gegenüber der Schmelzzone **2.1** thermisch und strömungstechnisch abschirmt.

Die in die Induktionsspule **3** eingespeiste Leistung bewirkt, dass sowohl das im Vorratsstab **1** befindliche Material geschmolzen wird, wodurch sich eine Abschmelzfront **1.1** herausbildet und das geschmolzene Material durch die Zentralöffnung **3.1** und die Öffnung **4.1** der Abschirmung **4** hindurch fließt. Gleichzeitig wird durch die Induktionsspule **3** auch die Schmelzzone **2.2** und das auf den wachsenden Kristallstab **2** geführte geschmolzene Material geheizt, so dass dieses beim langsamen Hinunterziehen des Stabes kristallisiert. Im gewählten Beispiel soll ein runder Kristall hergestellt werden. Der Durchmesser des Vorratsstabes **1** beträgt ca. 100 mm aus dem ein Kristall **2** mit einem Durchmesser von ca. 125 mm gezogen wird. Die Induktionsspule **3** sowie die Zentralöffnung **3.1** sind demzufolge ebenfalls rund. Die Durchmesser betragen 176 mm für die Induktionsspule **3** und 28 mm für die Zentralöffnung **3.1,** die Breite des Hauptschlitzes **3.2** beträgt 1,5mm.

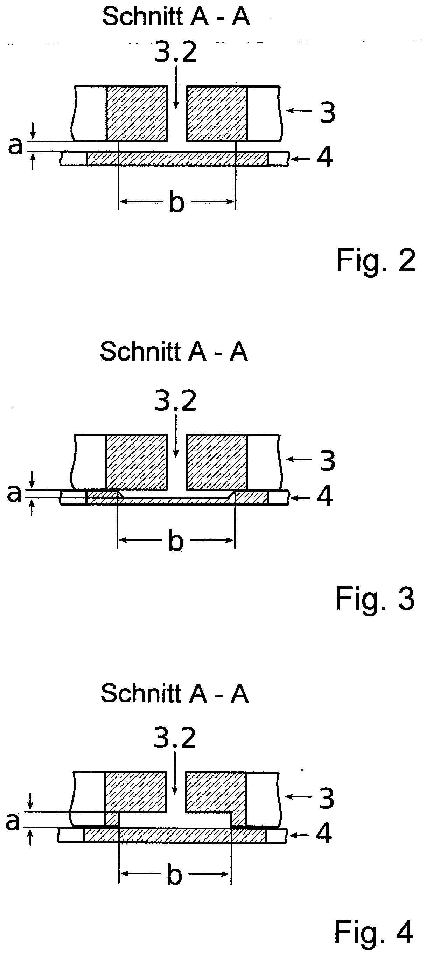

In der Fig. 2 ist ein Schnitt (A-A) durch einen Teil der Züchtungsanordnung, wie er in der Fig. 1 dargestellt ist, zu sehen. Ersichtlich sind der Hauptschlitz **3.2,** der Bereich **b** des Hauptschlitzes sowie der Abstand **a** zwischen der Abschirmung **4** und der Induktionsspule **3.**

Eine wesentliche Ursache des Entstehens von Überschlägen besteht darin, dass bis zu 1400°C heißes thermisch ionisiertes Gas zum Bereich hoher elektrischer Feldstärke in der Nähe des Hauptschlitzes **3.2** der Induktionsspule **3** gelangen. Außerdem wird durch schwebende Partikel, die sich generell verfahrensbedingt bilden, die Durchschlagsspannung in der Nähe der Induktionsspule **3** stark herabgesetzt. Um diese Ursachen auszuschließen oder zumindest stark zu verringern, ist unterhalb der Induktionsspule **3** eine Abschirmung **4** angeordnet. Die Abschirmung **4** ist im gewählten Beispiel mit einem Abstand **a** von ca. 1 mm unterhalb der Induktionsspule **3** angeordnet. Damit der Ziehprozess möglich ist, weist die Abschirmung eine Öffnung **4.1** auf, die der Zentralöffnung **3.1** der Induktionsspule **3** bezüglich Form und Position entspricht. Die Abschirmung **4** besteht aus einer ca. 1,5 mm starken Quarzglasscheibe. Die Quarzglasscheibe weist eine derartige Form auf, dass sie den Konturen der Induktionsspule **3** entspricht und somit der Abstand **a** zwischen der Abschirmung **4** und der Induktionsspule **3** an allen Stellen nahezu gleich groß ist. Dazu wurde die Quarzglasscheibe heißgeformt. Die Abschirmung **4** ist an mindestens drei Stellen durch am Rand der Induktionsspule **3** angebrachte metallische Laschen, die als Halterungen **5** dienen, lösbar mit der Induktionsspule **3** verbunden. Die Halterungen **5** sind im gewählten Beispiel gleichmäßig über den Umfang der Induktionsspule **3** verteilt an die Induktionsspule **3** geschraubt und sind beispielsweise über Langlöcher so eingestellt, dass ein definierter Abstand **a** zwischen Abschirmung **4** und Induktionsspule **3** gewährleistet ist. Die Abschirmung **4** hat einen Durchmesser von 150 mm und weist somit einen Außendurchmesser auf, der größer als der des Kristalls **1** als auch der Induktionsspule **3** ist.

Durch die Anordnung der Abschirmung **4** mit einem geringen Abstand unterhalb der Induktionsspule **3** und oberhalb der Schmelzzone **2.1** auf dem wachsenden Kristall **2** werden zwei wesentliche Ursachen, die zu Durchschlägen an der Induktionsspule **3** führen beseitigt. Zwischen der wassergekühlten Induktionsspule **3** und der Abschirmung **4** bildet sich ein Zwischenraum mit relativ kaltem Gas heraus. Die aus Quarzglas bestehende Abschirmung **4** stellt für das HF-Magnetfeld, das den Wärmeeintrag in die Schmelzzone **2.1** bewirkt, keine Beeinflussung dar, während sie die heißen Gase, die sich über der Schmelzzone **2.1** befinden, gegenüber der kalten Induktionsspule **3** in Zusammenwirken mit der "kühleren" Gasschicht thermisch isoliert. Außerdem bewirkt die Abschirmung, die vorzugsweise über die Induktionsspule **3** hinausragt, dass Partikel z.B. aus abdampfenden Silizium, die sich prozessbedingt über der Schmelzzone **2.1** befinden, nicht in die Nähe des Hauptschlitzes **3.2** der Induktionsspule **3** gelangen können, da sie um die Induktionsspule **3** herum gelenkt werden.
Ein weiterer Vorteil besteht darin, dass zwischen der Schmelzzone **2.1** mit einer hohen Temperatur von ca. 1400°C und der wassergekühlten Induktionsspule **3** mit um ca. 1000°C geringeren Temperatur, im Spalt zwischen Schmelze und Abschirmung **4** nicht so hohe Temperaturdifferenzen auftreten und somit wesentlich weniger Turbulenzen zu verzeichnen sind, was sich positiv auf das Kristallwachstum auswirkt.
Durch die weitgehende thermische Entkopplung zwischen Schmelzzone **2.1** und der wassergekühlten Induktionsspule **3** treten wesentlich geringere Energieverluste auf, was sich positiv auf die Energiebilanz des Herstellungsprozesses auswirkt.

In einer zweiten Ausführungsform der Erfindung ist ebenfalls eine großflächige Abschirmung **4** unterhalb der Induktionsspule **3** angeordnet, die die gesamte Induktionsspule **3** gegenüber der Schmelzzone **2.1** thermisch und strömungstechnisch abschirmt. In der Fig.3 wird der Ausschnitt (A-A) durch einen Teil der Züchtungsanordnung, wie er in der Fig. 1 dargestellt ist, für diese Ausführungsform gezeigt. Bei dieser Ausführung sind die Halterungen **5** derart eingestellt, dass die Abschirmung **4** aber nicht mit einem definierten Abstand zur Induktionsspule **3** angeordnet ist, sondern diese nahezu an allen Stellen, mit Ausnahme im Bereiches **b** des Hauptschlitzes **3.2,** direkt berührt. Die Abschirmung **4** ist in diesem Falle derart geformt, dass im Bereich **b** des Hauptschlitzes **3.2** der Induktionsspule **3** durch eine Verjüngung der Abschirmung 4 ein Abstand **a** von ca. 1 mm zwischen der Abschirmung **4** und der Unterseite der Induktionsspule **3** eingehalten ist. Diese Ausführungsvariante ist besonders geeignet, wenn z. B. zu Zwecken der Prozessbeobachtung ein möglichst großer Abstand zwischen der Abschirmung **4** und der Schmelzzone **2.1** erforderlich ist.
In der Fig. 4 ist ein Schnitt (A-A) durch einen Teil der Züchtungsanordnung, wie er in der Fig. 1 dargestellt ist, für die hier beschriebene Ausführungsform gezeigt, die eine Variante der zuvor beschriebenen Ausführung darstellt. Hier ist alternativ im Bereich **b** des Hauptschlitzes **3.2** der definierte Abstand **a** zwischen Abschirmung **4** und Induktionsspule **3** dadurch eingestellt, dass die Induktionsspule **3** im Bereich **b** des Hauptschlitzes **3.2** entsprechend dünner ausgestaltet ist, z. B. durch Fräsen einer entsprechenden Nut. Bei dieser Ausführung besteht praktisch kein Zwischenraum zwischen der wassergekühlten Induktionsspule **3** und der gesamten Abschirmung **4,** so dass sich ein Polster mit relativ kaltem Gas nur im Bereich des Hauptschlitzes **3.2** herausbilden kann. Die Abschirmung **4** besteht auch in diesem Beispiel aus einer ca. 1,5 mm starken Quarzglasscheibe.

In einer weiteren Ausführungsform der Erfindung, die nicht näher dargestellt ist, überdeckt die Abschirmung **4** nicht den gesamten Querschnitt des wachsenden Kristalls **2,** sondern es wird nur den Bereich **b** des Hauptschlitzes **3.2** der Induktionsspule **3** gegenüber der Schmelzzone **2.2** thermisch und strömungstechnisch abgeschirmt. Die Abschirmung weist beispielsweise die Form eines Kreissektors oder eines Streifens auf. Dieser Kreissektor bzw. Streifen besteht aus Quarzglas mit einer Dicke von ca. 1,5 mm. Der Kreissektor bzw. der Streifen ist mit einem Abstand **a** von ca. 1 mm unterhalb des Bereiches des Hauptschlitzes **3.2** der Induktionsspule **3** angeordnet. Vorzugsweise überdeckt die Abschirmung die Ränder des Hauptschlitzes um mindestens 1 cm nach jeder Seite und auch über den Radius der Induktionsspule hinaus. Somit wird gewährleistet, dass die bis 1400°C heißen thermisch ionisierten Gase nicht zum Bereich hoher elektrischer Feldstärke in der Nähe des Hauptschlitzes **3.2** der Induktionsspule **3** gelangen. Außerdem werden schwebende Partikel, die sich generell verfahrensbedingt bilden und die Durchschlagsspannung in der Nähe der Induktionsspule **3** stark herabsetzen, vom Hauptschlitz **3.2** fern gehalten.

### Aufstellung der verwendeten Bezugszeichen

- 1: Vorratsstab
- 1.1: Abschmelzfront
- 2: Kristall
- 2.1: Schmelzzone
- 3: Induktionsspule
- 3.1: Zentralöffnung
- 3.2: Hauptschlitz
- 3.3: Stromzuführung
- 4: Abschirmung
- 4.1: Öffnung in der Abschirmung
- 5: Halterungen
- a: Abstand zwischen Abschirmung und Induktionsspule
- b: Bereich des Hauptschlitzes der Induktionsspule

## Patentansprüche

1. Vorrichtung zur Herstellung von Kristallstäben nach dem tiegelfreie Floating Zone(FZ)-Verfahren bei dem als Heizquelle eine nur eine Windung aufweisende wassergekühlte Induktionsspule mit einer Zentralöffnung, die sich an den Hauptschlitz, der als Stromzuführung dient, anschließt, verwendet wird, bei der unterhalb der Induktionsspule (3) eine Abschirmung (4) aus einem elektrisch isolierenden und temperaturbeständigen Material angebracht ist, und der wachsende Kristall nach unten gezogen wird,
**dadurch gekennzeichnet, dass**
die Abschirmung (4) im Bereich (b) des Hauptschlitzes (3.2) in einem definierten Abstand (a) zur Unterseite der Induktionsspule (3) positioniert ist, wobei die Abschirmung den gesamten Hauptschlitz abdeckt und wobei zumindest der Bereich (b) des Hauptschlitzes (3.2) von der Abschirmung (4) überdeckt ist und die Abschirmung (4) den Hauptschlitz (3.2) um mindestens ca. 1 cm nach beiden Seiten und über den Radius des Kristalls hinausragt.

2. Vorrichtung nach Anspruch 1,
**dadurch gekennzeichnet, dass**
die Abschirmung (4) in Form einer kreisringförmigen Scheibe ausgebildet ist, deren zentrale Öffnung (4.1) der Zentralöffnung (3.1) der Induktionsspule (3) bezüglich Form und Position entspricht und deren äußerer Durchmesser größer als der Durchmesser des vorgesehenen Kristallquerschnitts und auch größer als der Durchmesser der Induktionsspule (3) ist, so dass die gesamte Induktionsspule (3) von der Abschirmung (4) überdeckt ist.

3. Vorrichtung nach Anspruch 1,
**dadurch gekennzeichnet, dass**
die Abschirmung (4) beispielsweise aus einem Kreissektor oder einem Streifen besteht, der den Hauptschlitz (3.2) um mindestens ca. 1 cm nach beiden Seiten und über den Radius des Kristalls hinaus, überragt.

4. Vorrichtung nach einem der vorhergehenden Ansprüche,
**dadurch gekennzeichnet, dass**
der Abstand (a) zwischen der Induktionsspule (3) und der Abschirmung (4) ca. das 0,2-fache bis 2-fache der Hauptschlitzbreite beträgt.

5. Vorrichtung nach Anspruch 1,
**dadurch gekennzeichnet, dass**
die Abschirmung (4) mittels Halterungen (5) lösbar an der Induktionsspule (3) befestigt ist.

6. Vorrichtung nach Anspruch 1,
**dadurch gekennzeichnet, dass**
die Abschirmung (4) eine Stärke von ca. 1,5 mm aufweist.

## Claims

1. An apparatus for the production of crystal rods according to the continuous floating zone (FZ) method, in which a water-cooled induction coil comprising only one turn and having a central opening is used, which central opening adjoins the main slot which serves as a power supply, wherein a shield (4) made of an electrically insulating and temperature-resistant material is provided beneath the induction coil (3), and the growing crystal is pulled downwards,,
**characterised in that**
the shield (4) is positioned in the region (b) of the main slot (3.2) at a defined distance (a) from the underside of the induction coil (3), wherein the shield covers the entire main slot and wherein at least the region (b) of the main slot (3.2) is overlapped by the shield (4) and the shield (4) projects by at least approximately 1 cm on both sides and beyond the radius of the crystal.

2. The apparatus according to claim 1,
**characterised in that**
the shield (4) is constituted in the form of a circular disc, the central opening (4.1) whereof corresponds to the central opening (3.1) of the induction coil (3) with regard to shape and position and that outer diameter whereof is greater than the diameter of the intended crystal cross-section and also greater than the diameter of the induction coil (3), so that the entire induction coil (3) is overlapped by the shield (4).

3. The apparatus according to claim 1,
**characterised in that**
the shield (4) comprises for example a circle segment or a strip, which projects beyond the main slot (3.2) by at least approximately 1 cm at both sides and beyond the radius of the crystal.

4. The apparatus according to any one of the preceding claims,
**characterised in that**
the spacing (a) between the induction coil (3) and the shield (4) amounts to approximately 0.2 times to 2 times the main slot width.

5. The apparatus according to claim 1,
**characterised in that**
the shield (4) is fastened releasaby to the induction coil (3) by means of holding fixtures (5).

6. The apparatus according to claim 1,
**characterised in that**
the shield (4) has a thickness of approximately 1.5 mm.

## Revendications

1. Appareil pour la fabrication de barreaux polycristallins selon le procédé de fusion en zone flottante (ZF) pour lequel on utilise comme source de chauffage une bobine d'induction refroidie à l'eau comportant seulement un enroulement avec une ouverture centrale, qui se raccorde à la fente principale qui sert à l'acheminement du courant, pour lequel un blindage (4) en matériau électro-isolant et résistant aux températures est appliqué en dessous de la bobine d'induction (3) et le cristal en cours de croissance est tiré vers le bas,
**caractérisé en ce que**
le blindage (4) dans la zone (b) de la fente principale (3.2) est positionné à une distance définie (a) par rapport à la face inférieure de la bobine d'induction (3), le blindage recouvrant toute la fente principale et au moins la zone (b) de la fente principale (3.2) étant recouverte par le blindage (4) et le blindage (4) dépassant la fente principale (3.2) d'au moins environ 1 cm vers les deux côtés et au-dessus du rayon du cristal.

2. Appareil selon la revendication 1,
**caractérisé en ce que**
le blindage (4) est constitué sous la forme d'une rondelle en forme d'anneau circulaire, dont l'ouverture centrale (4.1) de l'ouverture centrale (3.1) correspond à la bobine d'induction (3) concernant la forme et la position et dont le diamètre extérieur est plus grand que le diamètre de la section transversale du cristal et également plus grand que le diamètre de la bobine d'induction (3) de telle sorte que toute la bobine d'induction (3) est recouverte par le blindage (4).

3. Appareil selon la revendication 1,
**caractérisé en ce que**
le blindage (4) est composé par exemple d'un secteur de cercle ou d'une bande, qui dépasse la fente principale (3.2) d'au moins environ 1 cm vers les deux côtés et au-dessus du rayon du cristal.

4. Appareil selon l'une quelconque des revendications précédentes,
**caractérisé en ce que**
la distance (a) entre la bobine d'induction (3) et le blindage (4) est d'environ 0,2 fois à 2 fois la largeur de la fente principale.

5. Appareil selon la revendication 1,
**caractérisé en ce que**
le blindage (4) est fixé de façon amovible à la bobine d'induction (3) au moyen de fixations (5).

6. Appareil selon la revendication 1,
**caractérisé en ce que**
le blindage (4) comporte une épaisseur d'environ 1,5 mm.
